# EUROPEAN PATENT APPLICATION

(11) **EP 0 864 976 A1**
(43) Date of publication of application: **16.09.1998**
(21) Application number: 98830074.5
(22) Date of filing: 18.02.1998
(51) Int. Cl.: G06F 11/22

(54) **System for automatic fault searching applicable to any electronic digital equipment controlled by a processor**

(30) Priority: 27.02.1997 IT SA970005
(71) Applicant: Paolillo, Arturo, Cava dé Tirreni (SA) (IT); Santoriello, Guiseppe, Cava dé Tirreni (SA) (IT)
(72) Inventor: Paolillo, Arturo, Cava dé Tirreni (SA) (IT); Santoriello, Guiseppe, Cava dé Tirreni (SA) (IT)

(57) **Abstract**

Object of the present invention is a technology for searching an hardware fault in a electronic Printed Board Assembly (PBA) controlled by a processor without using any external test equipment. Purpose of this invention is a way to reveal an hardware faults among tracks connection or interposed devices, including processor bus tracks and any other tracks connected to whatever digital device's pins (we mention these pins as: "ports"). The present invention can be seen as divided in four different main topics:
1 - algorithmi
2 - additional digital circuit to be implemented in a device for processor bus's tracks check (Registers);
3 - additional digital circuit to be implemented in the same devices of previous point 2 for the extension of the test to the remaining port tracks (Digital cells for ports);
4 - PBA architecture for connecting processor, devices, modules.

## Description

### TECHNICAL FIELD

Object of the present invention is a technology for searching an hardware fault in a electronic Printed Board Assembly (PBA) controlled by a processor without using any external test equipment.

A processor essentially transfers data to/from devices or modules by three busses (data, address and control; we mention this as: "processor bus"); in order to connect the processor with devices and modules many and long tracks have to be used throughout any PBAs.

Purpose of this invention is a way to reveal an hardware faults among tracks connection or interposed devices, including processor bus tracks and any other tracks connected to whatever digital device's pins (we mention these pins as: "ports"); this is done neither using external test equipment nor other sort of instrumentation, in other words it's a technology for `design testability' that if applied to a generic PBA it will be able to diagnostic most hardware faults. The present invention can be seen as divided in four different main topics:
1.algorithm;
2.additional digital circuit to be implemented in a device for processor bus's tracks check (Registers);
3.additional digital circuit to be implemented in the same devices of previous point 2 for the extension of the test to the remaining port tracks (Digital cells for ports);
4.PBA architecture for connecting processor, devices, modules.

### BACKGROUND ART

A system called JTAG - Boundary Scan Test JTAG (IEEE 1149.1), like our invention, has the purpose to find out an hardware fault on a PBA, hereafter it is listed some needs for this system that will be overcome using this invention:
- use of jtag specialised serial bus;
- complex embedded hardware cells;
- external test equipment is a must;
- complex software to write;
- difficult and complex reports interpretation;
- I/O Signal delay increment.

### OBJECT AND IMPORTANT CHARACTERISTICS OF THE INVENTION.

First purpose of this invention is the enunciation of an algorithm able to be executed by whatever processor; second purpose is the definition of an electrical circuits to be built in any digital devices in order to apply this algorithm.

This technology applied on a PBA, in case of a fault, can notify by a whatever communication port, in very short time one or more of the following messages reported here as example:
- BUS DATA TRACK n IS STUCK TO ZERO/ONE.
- ADDRESS BUS TRACKS n AND m ARE SHORT-CIRCUITED.
- ADDRESS BUS TRACK n AND DATA BUS TRACK m ARE SHORT-CIRCUITED.
- DATA BUS TRACKS n AND m ARE SHORT-CIRCUITED.
- PORT TRACK n OF DEVICE x STUCK TO ZERO/ONE.
- PORT TRACKS n AND m OF DEVICE x ARE SHORT-CIRCUITED.
- PORT TRACK n OF DEVICE x AND DATA BUS TRACK m ARE SHORT-CIRCUITED.

In this example minus letters: n, m and x represent numbers to identify a track of the bus, or port, or device identity.

The system object of this invention can be applied to all electronic digital PBAs without alter hardware/software processor/device compatibility, for this reason has the potentiality to become an industrial standard.

This invention has following advantages if compared to the mentioned system JTAG:
- use of the device bus for processor connection;
- very simple embedded cells integrated in the device;
- external test equipment is not any more required;
- simple software to write;
- immediate reports interpretation.

Others advantages offered are listed:
1.fast and efficient PBA test (for example in automotive, military, medical , spatial applications);
2.test connection between modules (for example additional module in a personal computer) connected by back panel or cables;
3.automatic test equipment application;
4.reliability increase executing periodically the algorithm on a PBA without significantly affect system throughput;
5.possibility to define a software algorithm's library for all functions needed by this methodology without the effort to develop code for this application.

### DESCRIPTION OF THE DRAWINGS AND MODE FOR CARRYING OUT THE INVENTION

Objects, advantages and purposes of this invention will be better understood and appreciated by the following descriptions and annex figures:
Fig. 1. depicts buffer dominance;
Fig. 2. depicts processor driver dominance;
Fig. 3. depicts integration of registers in a device;
Fig. 4. depicts extension of integration registers in a device;
Fig. 5. depicts the tunnelling for input port;
Fig. 6. depicts the tunnelling for output port;
Fig. 7. depicts a cell as black box.
Fig. 8. depicts a device with input and output ports with additional cells;
Fig. 9. depicts architecture for methodology implementation;
Fig. 10. depicts methodology implementation in the processor;
Fig. 11. depicts flow-chart of algorithm's verifications.

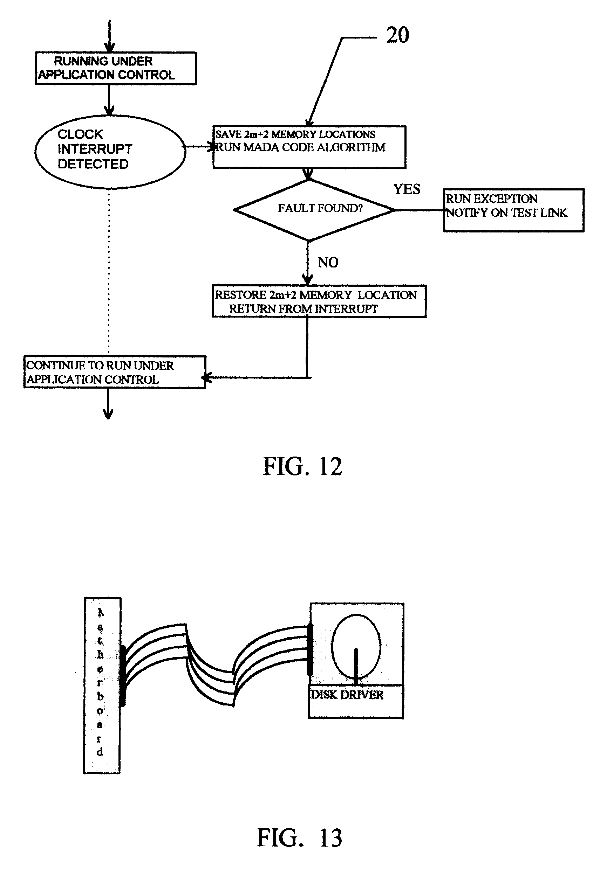

Fig. 12. depicts a way to increase system reliability;
Fig. 13. depicts modules connection test;
Fig. 14. depicts registers not addressable in case of short-circuit;
Fig. 15. depicts A.3.2 verification basic operations;
Fig. 16. depicts `IDLE' implementation.;
Fig. 17. depicts A.1.2 verification flow chart;
Fig. 18. depicts A.2.2 verification flow chart;
Fig. 19. depicts A.3.2 verification block diagram;
Fig. 20. depicts D.1.1(2) verification flow chart;
Fig. 21. depicts AD.1.4 verification flow chart;

The algorithm (20) object of this invention, is a set of necessary conditions but not sufficient because of the impossibility to catalogue all kind of faults on a PBA; preliminary concepts are introduced by some propositions and definitions.

Definition D.1 - Zero/one driver dominance.

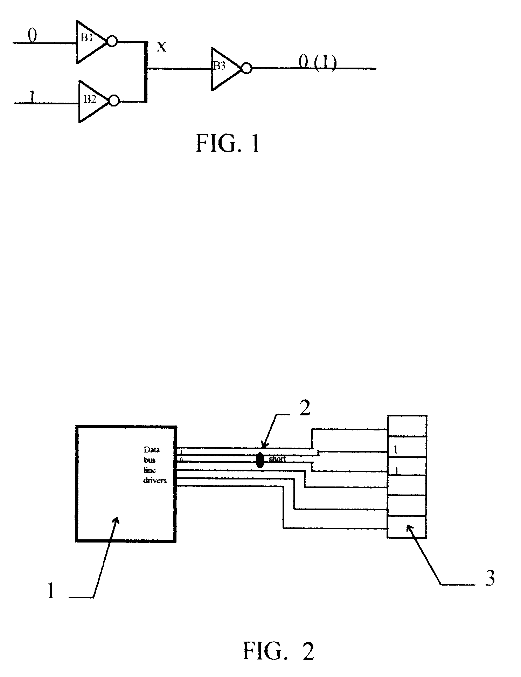

Given two devices trying to drive opposite logical values on a track, unknown X voltage values can represent the clashes because of the opposite signals, this value is given to an input buffer: if buffer's output is stable at zero(one) then the drivers are named zero(one) dominant. Refer fig. 1.

If the output is not stable the drivers are not dominant.

Definition D.2 - Zero/one circuit dominance.

If all the drivers of a circuit have the same dominance behaviour, the entire circuit is called zero or one dominant.

Proposition P.1 - Data bus dominance.

When a processor execute a write-read cycle toward a register, in case of a clash, the dominance is only defined by the processor drivers dominance activated during the write.

The dominance of the drivers activated during the read are don't care.

Fig. 2 shows an example of driver dominance.

Definition D.3 - Track stuck.

A track can be stuck to zero or one if the logical value on it does not change when the driver attached try to negate the actual value on it, this can happen for one of these reasons:
- the track is short-circuited with the power supply;
- the track is short-circuited with another track;
- the track is interrupted;
- the driver of the track is broken.

Definition D.4 - Secondary and Primary busses.

It is called 'secondary bus' a generic bus such that a fault on it does not compromise the execution of the algorithm (20) and besides the fault can be revealed by the algorithm execution: secondary busses can be more than one on a PBA.

Primary bus, unique in a processor system, always connects a non volatile Memory (ROM) where algorithm's code resides, it can be physically implemented in different ways:
- as tracks on the PBA (PBA requirement);
- as internal processor bus (Integrated in the processor chip);
- as external tracks ( Externally implemented as an isolated probe of an Emulator).

All devices equipped with read/write registers and data/address/control busses
(memory, I/O devices, modules, etc.) can be classified on the basis of the algorithm (20) applicability: partial or total.

The algorithm can be applied to whatever electronic device controlled by processor busses, a general device has:
- data bus 'n' width;
- address bus 'm' width (physical addressable 2**m location);
- '1' read/write registers;

Algorithm (20) is a set of verifications, put in a particular hierarchical execution order, able to reveal detailed fault on processor data/address/control busses.

Verifications are put in a particular hierarchical order, in a way that if fault is reported by a verification, higher in the order, this is much more probably true than the eventual other next verification's reports lower in the hierarchical.

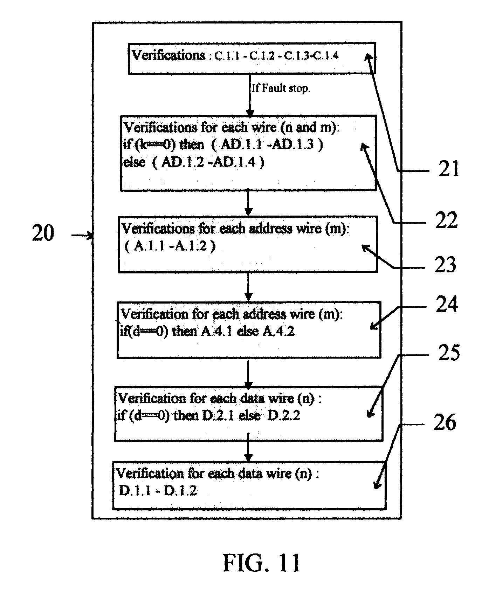

Fig.11 depicts verifications order, that should be:
1) CONTROL BUS VERIFICATION (21).
2) SHORT-CIRCUIT BETWEEN ADDRESS AND DATA TRACKS (22).
3) STUCK ON ADDRESS BUS TRACK TO ZERO OR ONE (23).
4) SHORT-CIRCUIT BETWEEN TWO ADDRESS BUS TRACKS (24).
5) SHORT-CIRCUIT BETWEEN TWO DATA BUS TRACKS (25).
6 ) STUCK ON DATA BUS TRACK TO ZERO OR ONE (26).

At beginning of the algorithm, verifications (21) are reported to check processor control bus then follows necessary conditions for bus faults discovering; generally one fault on control bus makes faulty whatever other verifications on the busses. Verifications from (22) to (26) are enunciated as necessary but not sufficient conditions. In case a verification higher in the hierarchical reports a fault, the algorithm does not stops and proceed for lower verifications, because eventual other reports can be interpreted by a software filter machine or simply by an operator in order to report a more probable fault.

Note that it is possible to define a function of general use applicable to each device to be tested, it has following input parameters:
- n, data bus width;
- m, address bus width ;
- t, device type (A, B, C0, C1, D);
- b, device base address;
- l, dominance of processor line driver (0 or 1);
- k, gives indication of the behaviour when bus is in a fault condition, e.g. short-circuits between data and address tracks;
- f , access type and control configuration; and it has as output a report of the fault found code;
then a software filter takes the fault code as input and elaborates the fault indication by a visual indicator to an operator or to other equipments.

The parameter `k' gives an indication of the type of electrical circuit behaviour when it is in a fault state; the user can decide at set up which parameter `k' to use by simulating any fault on the particular board and examining the result.

The algorithm introduced is based on some verifications as hereafter reported having the ability to deliver full diagnostic information to determine all failing data bits and addresses.

Given a device (n, m) with n data tracks and m address tracks it is possible to enunciate:

### -STUCK ON ADDRESS BUS TRACK TO ZERO OR ONE-

Verification A.1.1- Said `x' a value read at address zero,
   write the inverted of `x' at address 2**i,
   said `z' a next reading at address zero, a necessary condition that an address `i' is stuck to zero is that `z' is not equal to `x'.
   Let's explain this verification:
   supposing a processor has an address track `i' stuck to zero, when it try to address the register located to the address 2**i, it actually address location address zero, then only this location is affected with the two writings of `y' and its negated and the two next readings which values are pushed in `x' and `y' variables.
   Next proposition has an extended validity compared to A.1.1.
Verification A.1.2- Write whatever value `y' at address zero,
   read `x' at same address zero,
   write the inverted of `x' at address 2**i,
   said `z' a next reading at address zero, a necessary condition that an address `i' is stuck to zero is that `z' is not equal to `x'.

In this case there is the condition that when a value is written at address zero not necessary the read back is equal to the value written because one or more trucks can be stuck.

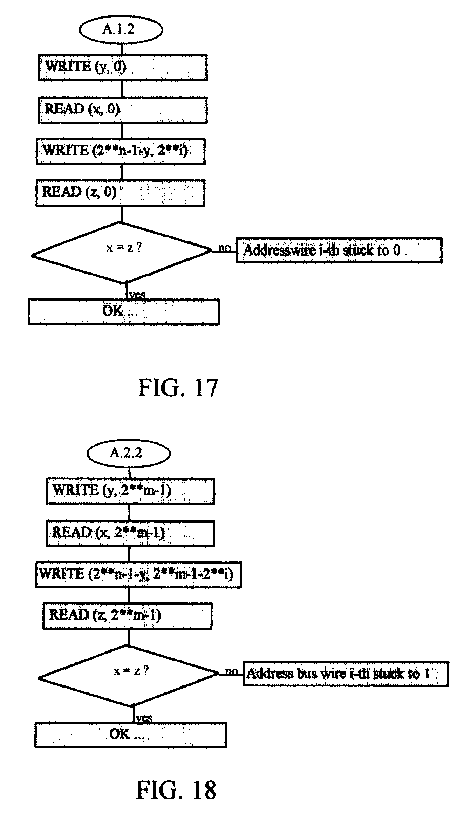

Fig. 17 depicts block diagram of A.1.2 verification.

The convention WRITE(A,P) represent a write cycle of the value A at address pointed by P.
Verification A.2.1 - Said `x' a value read at address (2**m-1) (...FFFF hex),
   write the inverted of 'x' (exclusive OR of x) at address (2**m-1 -2**i),
   said `z' the next reading at address (2**m-1), a necessary condition that an address `i' is stuck to one is that `z' is not equal to `x'.
Verification A.2.2 - Write whatever value `y' at address (2**m-1),
   read `x' at same address,
   write the inverted of 'y' (exclusive OR of y) at address (2**m-1 -2**i),
   said `z' the next reading at address (2**m-1), a necessary condition that an address `i' is stuck to one is that `z' is not equal to `x'.

Fig. 18 depicts flow-chart of A.2.2 verification.

### - SHORT CIRCUIT BETWEEN TWO ADDRESS BUS TRACKS -

Given a device(n, m) with n data tracks and m address, suppose control bus not faulty:
Verification A.3.1 -
   Given a 'zero dominant' electrical circuit and suppose that, for verification A.1.1, two address tracks: 'i' and `j' are stuck to zero,
   read a value `x' at address zero,
   write the inverted of `x' (^x) at address (2**i+2**j),
   and read 'z' at address zero:
   a necessary condition that an address `i' is short-circuited to `j' is that `x' is not equal to `z', of course if `x' is equal to `z' means that `i' and `j' tracks are both stuck to zero.
   If bus data is affected by a problem is possible to extend A.3.1 validity:
Verification A.3.2 -
   Given a 'zero dominant' electrical circuit and suppose that, for verification A.1.1, two address tracks: 'i' and `j' are stuck to zero,
   write whatever value `y' and read a value `x' at address zero,
   write the inverted of `y' (^y) at address (2**i+2**j),
   and read 'z' at address zero:
   a necessary condition that an address `i' is short-circuited to `j' is that `x' is not equal to `z', of course if `x' is equal to `z' means that `i' and `j' tracks are both stuck to zero.

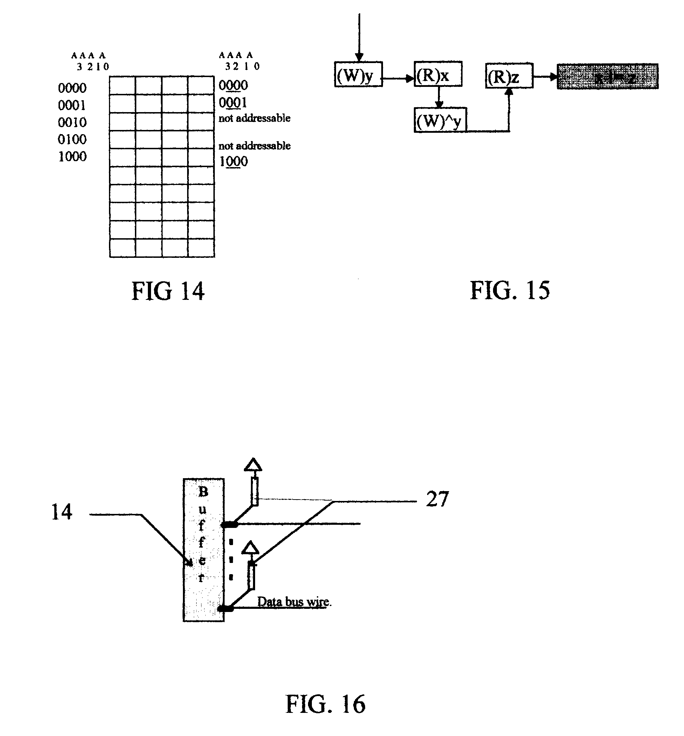

In the fig. 15 is depicted, in a chronological order, the reading (R ) and writing (W) cycles needed for verification A.3.2. In the fig. 14 is indicated, in the left side, the processor addressing, because it is supposed a short-circuits between address A1 and A2 in the right side is indicated the effective addressing.

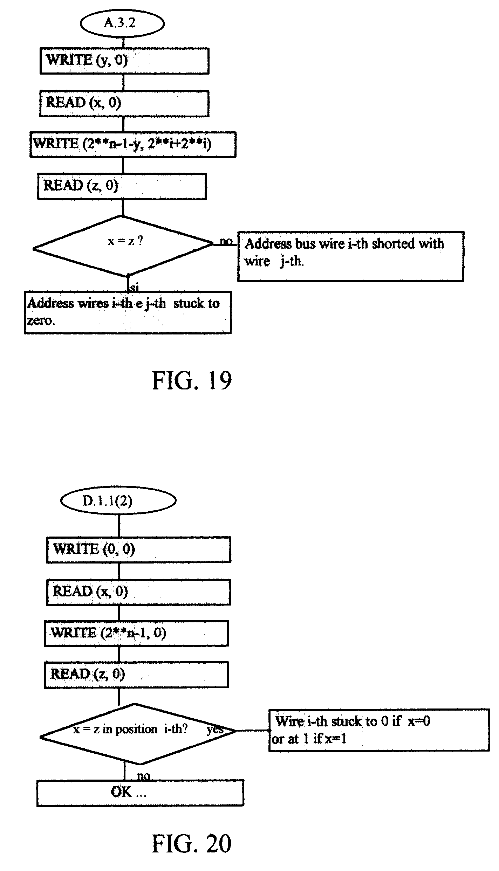

Fig. 19 depicts the flow-chart of A.3.2 verification.

Verification A.4.1 - Given an 'one dominant' electrical circuit and suppose that, for
verification A.2.1 - two address tracks: 'i' and `j' are stuck to one,
   read a value `x' at address (2**m-1),
   write the inverted of `x' (^x) at address (2**m-1-2**i-2**j),
   and read 'z' at address (2**m-1),
   a necessary condition that an address `i' is short-circuited to `j' is that `x' is not equal to `z', of course if `x' is equal to `z' means that `i' and `j' tracks are both stuck to one.
Verification A.4.2 -
   Given an 'one dominant' electrical circuit and suppose that, for verification A.2.1, two address tracks: 'i' and `j' are stuck to one,
   write whatever value `y' and read a value `x' at address (2**m-1),
   write the inverted of `y' (^y) at address (2**m-1-2**i-2**j),
   and read 'z' at address(2**m-1),
   a necessary condition that an address `i' is short-circuited to `j' is that `x' is not equal to `z', of course if `x' is equal to `z' means that `i' and `j' tracks are both stuck to one.

### - DATA BUS TRACK STUCK TO ZERO OR ONE -

These verifications can be done also in case of stuck on address bus.
Verification D.1.1-
   Said `x' a value read at whatever register address,
   write the inverted of `x' (^x) and read `z' again at the same address;
   a necessary condition that an address `i' is stuck to zero is that the bit in position of 2**i of `x' and `z' is always zero.
Verification D.1.2-
   Said `x' a value read at whatever register address,
   write the inverted of `x' (^x) and read `z' again at the same address;
   a necessary condition that an address `i' is stuck to one is that the bit in position of 2**i of `x' and `z' is always one.

Fig. 20 show flow-chart of data verification.

### - SHORT CIRCUIT BETWEEN TWO DATA BUS TRACKS -

Verification D.2.1 -
   Given an 'zero dominant' electrical circuit and suppose that
   a write and read-back of values: 0 and (2**n-1) are correct at one address,
   write the value (2**n-1-2**i) it read a value `x' at same address,
   a necessary condition that a data `i' is short-circuited to `j' is that `x' is equal to the value (2**n -1-2**i-2**j).

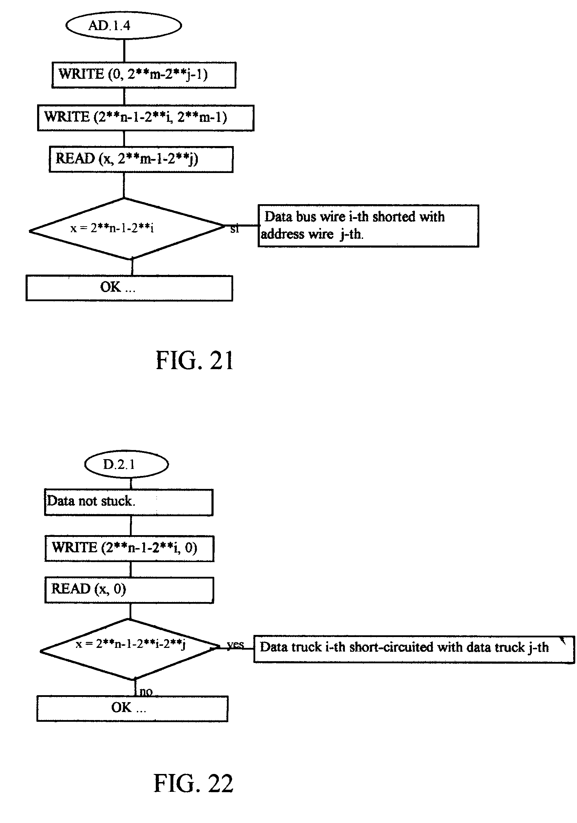

Fig. 22 depicts flow-chart of D.2.1 verification.
Verification D.2.2 - Given an 'one dominant' electrical circuit and suppose that
   a write and read-back of values: 0 and (2**n-1) are correct at one address,
   write the value (2**i) it read a value `x' at same address,
   a necessary condition that a data `i' is short-circuited to `j' is that `x' is equal to the value (2**i+2**j).

### - SHORT CIRCUIT BETWEEN ADDRESS TRACK AND DATA TRACK -

Verification AD.1.1-
   Given an 'one dominant' electrical circuit and considered a data track 'i' and an address track 'j',
   suppose that a write and a read-back at address 0 of data 0 is correct,
   and also a write and a read-back at address (2**m-1) of value (2**n-1) is correct,
   write the value 2**n-1 at address 2**j,
   write the value 0 at address 2**j and read `x' at address 2**j,
   a necessary condition that a data `i' is short-circuited to address `j' is that `x' is equal to the value 2**i.
Verification AD.1.2-
   Given an 'one dominant' electrical circuit and considered a data track 'i' and an address track `j',
   suppose that a write and a read-back at address 0 of data 0 is correct,
   and also a write and a read-back at address (2**m-1) of value (2**n-1) is correct,
   write the value 2**n-1 at address 2**j,
   write the value 2**i at address 0 and read `x' at address 2**j,
   a necessary condition that a data `i' is short-circuited to address `j' is that `x' is equal to the value 2**i.
Verification AD.1.3-
   Given a 'zero dominant' electrical circuit and considered a data track 'i' and an address track 'j',
   suppose that a write and a read-back at address 0 of data 0 is correct,
   and also a write and a read-back at address (2**m-1) of value (2**n-1) is correct,
   write the data 0 at the address 2**m-2**j-1, write the data (2**n-1) and read `x' at the address 2**m-2**j-1,
   a necessary condition that a data `i' is short-circuited to address `j' is that `x' is equal to the value (2**n-2**i-1).
   or , as alternative,
Verification AD.1.4-
   Given a 'zero dominant' electrical circuit and considered a data track 'i' and an address track 'j',
   suppose that a write and a read-back at address 0 of data 0 is correct,
   and also a write and a read-back at address (2**m-1) of value (2**n-1) is correct,
   write the data 0 at the address 2**m-2**j-1, write the data (2**n-1) and read `x' at the address 2**m-2**j-1,
   a necessary condition that a data `i' is short-circuited to address `j' is that `x' is equal to the value (2**n-2**i-1).

### - STUCK ON CONTROL BUS -

Given a device (n, m) with n data tracks and m address, it is possible to assert a number of sufficient conditions but not necessary in order to check if bus control is affected by a stuck:
Verification C.1.1-
   Write a value `y' at whatever address and read-back `x',
   then write `y' inverted and read-back `z',
   sufficient condition but not necessary for control bus track fault is that `x' is equal to `z'.
Verification C.1.2-
   Write at address 0 and 2**m-1 of data not equal to the `idle' value, read `x' at the same address, sufficient condition but not necessary for control bus tracks fault is that `x' is equal to `idle' value.
Verification C.1.3- Control bus track is stuck if reading always at the same address, at least once the value read is not equal to the previous one.
   This condition is only sufficient but not necessary.
Verification C.1.4- Control track is stuck if writing whatever values at whatever address and reading back the value does not change.

This condition is only sufficient but not necessary.

During code development, keep in count that parasitic capacitance could give a memory effect, so between a write and a read it is recommended interleaved write cycle of a inverted value of that is expected in reading but addressed to a not used register.

The `IDLE' value is read at the address where is not mapped any registers, most of time the device remain in three state thus. (27) depicts idle implementation: resistors should be placed as close as possible to buffer pins with independent tracks as in fig. 16.

The algorithm (20) can be more or less fault covering dependent on the device registers map, because of this, devices can be divided in four classes named with letters from A to D (follow in brackets data and address busses widths), each class including the other in a hierarchical order:
- A(n, m) type device;
- B(n, m) type device;
- C(n, m) type device;
- D(n, m) type device;

Definition D.5: Device 'A(n, m)' type.

Devices of this class include a continuity of 1 = 2**m read/write registers each one is addressable from [0, 2**m-1].

Memories typically are included in this class.

Definition D.6: Device `B(n, m)' type.

Devices of this class have following properties:
- at least l = (m+1)*2 read/write registers;
- m registers have address 2**i with i belonging to [0,m-1];
- m registers have address 2**m-2**i-1 with i belonging to [m,2*m-1];
- one register has address 0;
- one register has address 2**m-1;
- remaining registers, if any, have address don't care.
- each reading to address where it is not mapped any register will drive always the same value or remain in high impedance.

The algorithm (20), for this device class, has almost the same coverage of class A, however, in case of multiple short-circuit among more than three address tracks gives good indication if the stuck are all at one or at zero.

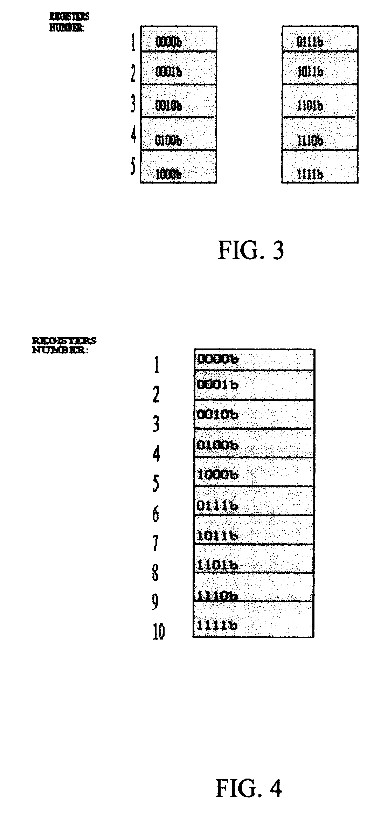

Fig. 4 depicts, as example, all specified registers for m=4. It should be noted all the (m+1)*2 registers are not specialised for the algorithm use, but they can have whatever function during normal device working.

Note `B' class devices have many less registers of class A devices and it is recommended for a new device implementation with the principal aim to test processor busses state.

It must be highlighted that devices of `B' class is an essential part of this invention, will be explained how this registers map will be used in a more extended way to build devices for the Automatic Fault Searching.

Fig. 4 depicts B registers map.

Definition D.7: Device `C(n, m)' type.

Devices of this class can have either following properties :
- at least l = (m+1) read/write registers;
- m registers have address 2**i with i belonging to [0,m-1];
- one register has address 0;
- remaining registers, if any, have address don't care.
- each reading to an address where is not mapped any device's registers will drive always the same value or remain in high impedance.

As alternative:
- at least l = (m+1) read/write registers;
- m registers have address 2**m-2**i-1i with i belonging to [0,m-1];
- one register has address 2**n-1;
- remaining registers, if any, have address don't care.
- each reading to an address where is not mapped any device's registers will drive always the same value or remain in high impedance.

To distinguish these two alternatives the class C have two subclasses named: C0 and C1 respectively.

The difference between the two classes is in the address duality.

In this case the algorithm can be applied with following limitations:
- for C0 eventual stuck to one will not be revealed;
- for C1 eventual stuck to zero.

Fig. 3 depicts C0 and C1 registers map.

Definition D.8: Device `D(n, m)' type.

Devices of this class have only one read/write register. I this case it can be used only for checking data bus.

On a PBA with processor are normally used more than one device (gate arrays) that can be classified, as mentioned before, in one of the classes A(n,m), B(n,m), C(n,m), D(n,m).

Definition D.9: Device's PORT.

A device has some terminals connected to an internal logic, not related to processor busses, for input or output purpose, all this terminals are called here: `ports'.

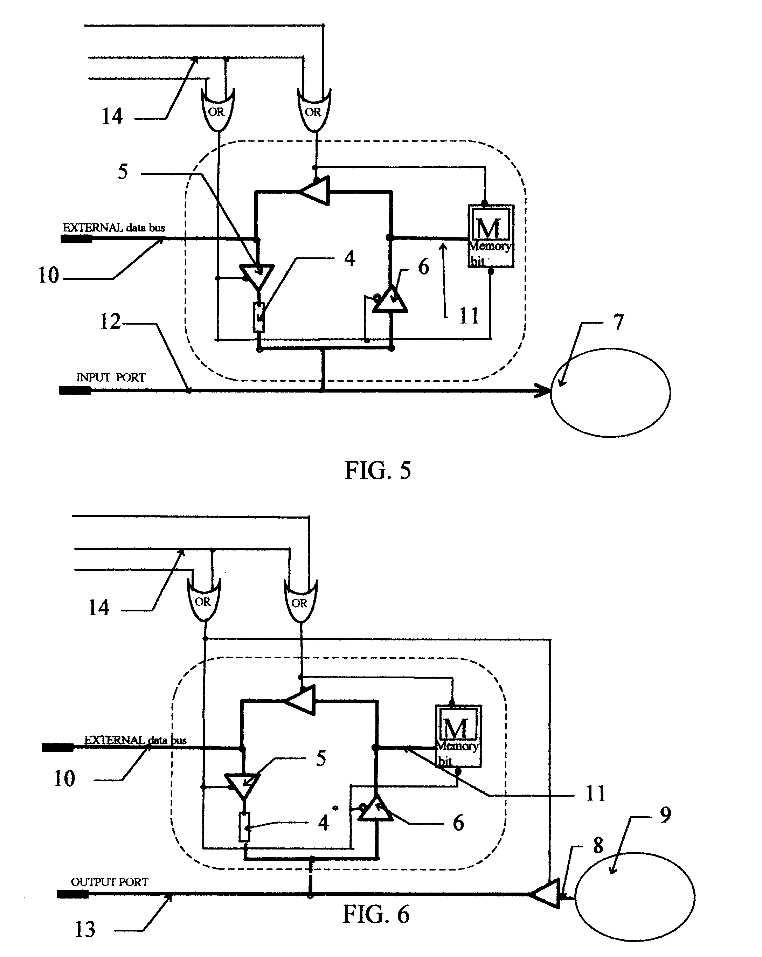

Applying the methodology object of this invention and adding a special logic for each device's port as depicted in fig. 5 and fig. 6 it is possible to check port connection like data bus connection, this concept it is called here: 'tunnelling' and it is a main point for this methodology.

For each port that has to be checked, the tunnelling can be implemented inside the device as described hereafter, during this description it is supposed that the device has busses connections towards the processor, this constrain will be overcome:

For one data bus internal wire, connected to an external pin, it is attached a cell, obtaining a split of the bus in two electrical and logical busses, for convention it is called external bus (10) and internal bus (11), of course both are internal to the device.
- By enabling two buffers (5) and (6), the external data bus wire is connected to a input or output port (12) or (13) and besides connected to the internal bus wire (11). In the device is established a correspondence between a port and a data bus wire.

Output port can be isolated from internal logic by a third buffer (8), besides it can be equipped by a multiplexer controlled by the processor before the buffer in order to impose a fix logic value on the port, this it is useful to check logically the external circuits .

With this implementation, in the test phase and during write cycles, the logic level present on a port is forced to follow the same logic level driven by the processor on the data bus wire.

If the port is stuck at zero or one, during write cycles, it will not allow to the memory cell to latch a value not equal to the stuck value, in other words the stuck will be transferred at logical level, from the port to the bus data, so that the algorithm (20) is able to discover stuck on the port as it were a stuck on data bus. In order to interpreter the algorithm results, in case of ports, is useful to do distinction between output and input ports.

Output port (13): the test on these ports has the purpose to verify that connections from the driver associated to this port and input ports are in high impedance; in case of fault because of a stuck, the algorithm will report a stuck on the respective bus data wire associated to the port.
- For instance, if port `x' is associated to data bus wire 'y', the algorithm reports the fault as it were the stuck on data wire `y'.
- Then this method allow to point out eventual stuck or short-circuit between the port and any bus's wire or any other port.
- Input port (12): the test on this port has the purpose to verify that there is a connections towards a driver.
- It is useful to do distinction: the signal driven to the input port can be stable at certainly logic level (0/1) or can be periodically alternated .
- In case it is driven always at one or zero the algorithm should report stuck, in fact an input port is driven by an output port at low impedance.
- The user has to also verify that this stuck is at the desired value. If on an input port is not reported a stuck this will sign the non electrical connection with a driver, for example this is the case of not soldered pin or track interrupted.

If the algorithm reports the stuck value not equal to the one expected a further analysis can be required to discern the origin of the fault, for example can be a fault in the Boolean logic or a stuck with another net.

In case the input port is driven by an alternated signal has to be used a statistical method: the algorithm for the port check has to run many times in order to find at least once a stuck to zero and once a stuck to one.

Example: supposing to have at input port an asynchronous signal compared to the processor clock with a duty cycle of fifty per cent, each verification has the probability to find a stuck to zero equals to 0.5 then after `n' times the probability to find a stuck to one and a stuck to zero is equal to (1-0.5**n), close as much as it needs to one after `n' verifications; the user has to choose `n'.

In order to implement the port verification, devices must have additional logic as depicted in fig. 6 for each port considered.

The resistor (4) represents output driver impedance connected to it, the value can be around a thousand Ohm or less, with (13) is indicated output port `y' with its control logic, with (10) external data bus wire `x', with (11) internal data bus wire `x', with (12) and (7) input port and control logic, with (9) output port control circuit.

Note that the number of ports that can be tested is not constrained to the bus data width, because the same data bus wire can be used to test more than one port making separated enabling selection for each port.

In order to discover port fault, it is possible to use the same algorithm (and code) used for data bus checking, providing to put the device in a port test modality before to execute the algorithm.

A module, additional boards plugged or connected by cables on a mother board (Ex.: Boards in Personal Computer), can be considered from the methodology point view like a device, then it is possible apply the tunnelling for each port, obtaining a connection highly testable.

In a electronic system the `tunnelling' gives following additional features:
- no code to develop for checking ports;
- easy and ready report interpretation;
- detailed fault report: track interruption, short-circuits with other tracks, stuck;
- in most cases only one dedicated pin has to be added;
- very flexible for new features adding, this methodology can be considered as the base for new feature implementations, e.g. for output port foreseen a multiplexer to force a logical value in order to test the external circuits.
- the processor itself can use the 'tunnelling' for checking its ports.

The test selection can be done in different ways, for example:
- by an internal protected register, in order to select a group of ports or registers.
- by external pins dedicated to this application and some internal registers; for example (14) in fig. 5 and fig. 6.

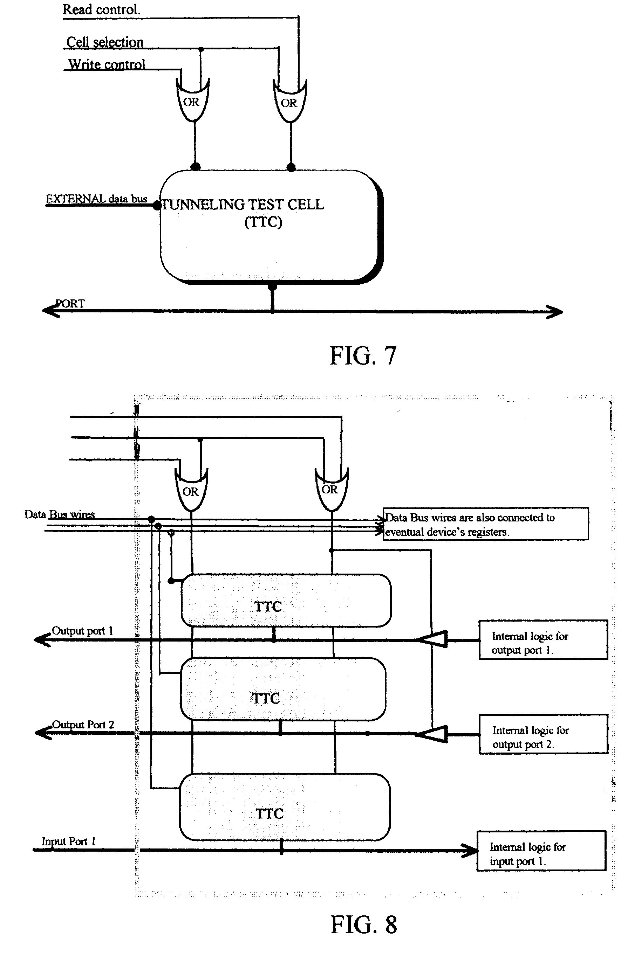

Fig. 7 depicts such solution with input and output ports.

The architecture of systems controlled by processors in order to support this methodology must have the fundamental characteristics to owe one or more secondary busses; only in this case the processor is able to execute the algorithm in case of fault on the secondary busses controlled by it.

It has also to be notice that in case of no secondary bus the methodology can also be advantageously implemented in a PBA, in fact there are no possibility for busses checking but it is possible to check: device connections with busses and input/output ports.

It is then possible to discriminate different implementation for this architecture: from simple trick to keep present during system design to circuits integration in the processor chip, as reported in the following implementations:
- 1) External buffers to the processor's busses with the purpose to electrically isolate the busses from the devices connections in order to distinguish one primary bus and at least one secondary bus.
- 2) Buffer isolation inside the processor with integration of the primary bus inside the processor chip and with one secondary bus for outside connection to devices.

Of course has to be integrated a memory inside the processor for containing the executable code in the device and a serial port for the external reporting.

Note that the implementation of a secondary bus can be obtained on whatever existing processor systems easily using either emulators with isolated probe or test equipment and implementing the primary bus inside these machines.

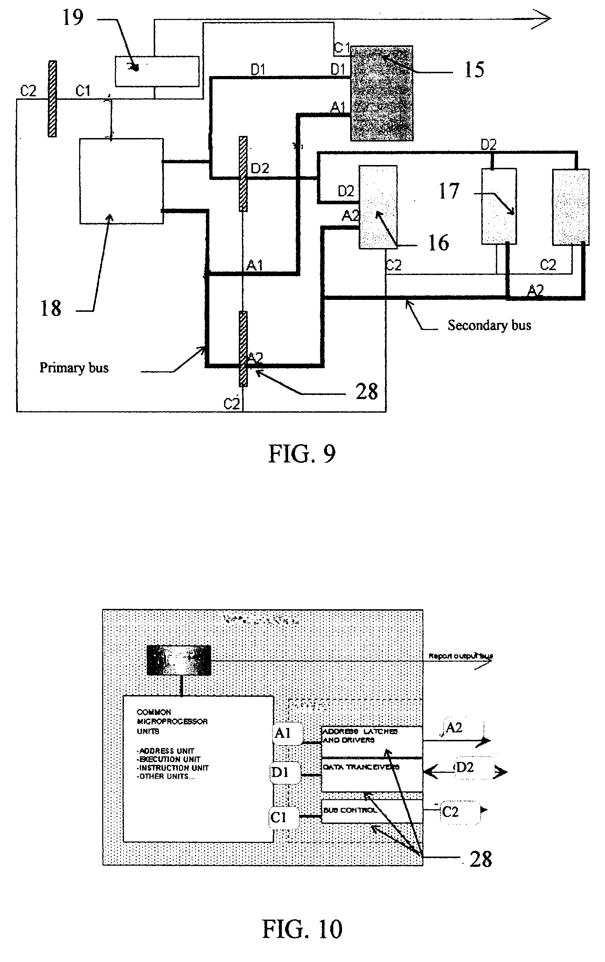

A system in the first case, see Fig. 9, has to have for each bus (address, data, control) an electrical separation in two independent busses, one is called primary and the other(s) secondary bus(ses).

Primary bus is used to `fetch' algorithm code in a Read Only Memory, write and read data variables, send reports to a communication port;
all these busses have as short-circuit and visible as possible tracks on PB (Printed Board) such that they have a low probability to get stuck and also to evidence problems easily because code is not able to run if there is a fault on it.

The busses involved in the algorithm analysis, called secondary busses, are the ones extend all over the PBA and used for connecting all devices and modules.

In fig. 9 the primary bus is identified by D1, A1, C1 connected to processor (18), a non volatile memory (ROM) (15), a decoder logic, a communication port (19).

Fig. 10 depicts the architecture that is possible to integrate in the processor itself, in this case the maker can introduce in their processors a new feature keeping hardware and software compatibility. In case of fault the processor can use all its internal units, and because the algorithm has not many code lines it can be put, for instance, fixed inside the processor or loaded by the communication port, verifications can be activated autonomously or by an external pin.

## Claims

1. Method for automatic test applicable to any system controlled by a processor consisting in a set of verifications, executed by the processor of system itself in a chronological order, in order to check and find out an hardware fault among processor busses - address bus, data bus, control bus - and able to send reports of the faults found by a communication port to an external receiver without using any additional test equipments characterised by the fact that verifications are executed in a way that the probability to be true of one reported fault is higher than the probability of a fault reported by next verifications; verifications find faults in the following order:
A) control bus verification;
b) short-circuit between address bus wire and data wire;
c) stuck at zero or one on address bus;
d) short-circuit between two address bus wires;
e) short-circuit between data bus;
f) stuck at zero or one of data bus wire;
g) short-circuit between address bus wire and port wire;
h) short-circuit between ports;
i) stuck at zero or one of port wire;
With verifications A) all sufficient condition to break the algorithm (20) are checked, if fault is located on the control bus (e.g. stuck of chip select, random data readings, ...) algorithm is stopped because all next verifications will report only virtual problems; in case verifications A) does not found any problem, the algorithm (20) executes verifications from B) to F) and if still none is found it continues with verifications G), H) and I). All verifications, but not A), are necessary conditions.

2. Method as claim 1) with the characteristic to find out a fault on a whatever digital device's pin (port) using a circuit (cell), -figures 5,6,7,8-built in the device for each pin and using the same algorithm (20)for processor busses check.

3. Method as claims 1), 2) able to notify in a fast way a following type of messages:
- data wire `x' stuck to zero;
- data wires `x' and `y' short-circuited;
- data wire `x' and address wire `y' short-circuited;
- address wires `x' and `y' short-circuited;
- port `x' stuck to zero;
- ports `x' and 'y' short-circuited;
Variables `x' and `y' are used to represent the physical wire connected to processor or device.

4. Method as previous claims which uses an algorithm that is of general use for all electric circuits controlled by processor, in particular it has following input parameters:
- n, data bus width;
- m, address bus width ;
- t, device type (A, B, C0, C1,D);
- b , device base address;
- l, dominance of processor line driver (0 or 1);
- k, gives indication of the behaviour when bus is in a fault condition, e.g. shorts between data and address tracks;
- f , access type and control configuration;
and it has as output a report of the fault found code that it is given outside in some way for an operator or machine;

5. System architecture (9 with a processor (18) where each bus (address, data, control) is electrically divided, by interposition of buffers (28), in at least two physical busses, called `primary bus' (C1, A1, D1) or system bus where instruction code algorithm is fetched, a fault on this bus will affect the right algorithm execution; one or more `secondary bus' (C2, A2, D2) such that a fault on it can be found out by algorithm and notified outside the system. It is possible to assert: the algorithm (20) is executed by mean of the primary bus for analysing secondary busses.

6. System architecture as claim 5) but with the primary bus integrated in the processor fig. 10 in order to be able to execute the algorithm (20) in case of fault outside the processor chip.

7. Generic digital device connecting a data bus width of `n' wires and address bus of `m' wires, with at least (m+1) read/write registers mapped as in fig. 3 and fig. 4, with the characteristic to support the algorithm (20) in order to verify the connections to busses:
- m registers have address 2**i with i:[0, m-1]
- or/and m registers of address 2**m-2**i-1 with i:[m, 2**m-1]
- register of address 0 and/or 2**m-1

8. Generic device as claim 7) (registers and mapping) without external processor bus and connected by any serial bus in order to reduce the number of termination (pins) in case of the device does not foreseen the processor parallel bus connection .

9. Generic device fig. 8 where at some input or output pins are connected, integrated in the device, an electrical circuit -figures 5, 6, 7 - formed by a separator resistor (4) and some buffers (5) (6) (8) in order to check connections towards other devices.
